# EUROPEAN PATENT APPLICATION

(11) **EP 4 174 957 A1**
(43) Date of publication of application: **03.05.2023**
(21) Application number: 22204823.3
(22) Date of filing: 31.10.2022
(51) Int. Cl.: H01L 31/02, H01L 23/00, H01L 31/073, H01L 31/0735, H01L 31/0749, H01L 33/62

(54) **SEMICONDUCTOR DEVICES WITH ELECTRICALLY CONDUCTIVE ADHESIVE**

(30) Priority: 01.11.2021 GB 202115650
(71) Applicant: Lightricity Ltd, Oxford, Oxfordshire OX4 4GB (GB)
(72) Inventor: BELLANGER, Mathieu, Oxford, OX4 4GB (GB); KAUER, Matthias, Oxford, OX4 4GB (GB)
(74) Representative: Dehns

(57) **Abstract**

A semiconductor device (30) comprises a semiconductor portion (23, 24), a support substrate (20), and an electrical conductor (21) for passing an electrical current to or from the semiconductor portion (23, 24). The semiconductor portion (23, 24) is bonded to the support substrate (20) by an electrically conductive adhesive (22), which is in direct ohmic contact with a doped contact layer (23) of the semiconductor portion (23, 24) and which is additionally in direct ohmic contact with the electrical conductor (21). The electrically conductive adhesive (22) is arranged such that all electrical current passing to or from the semiconductor portion (23, 24) travels through the electrically conductive adhesive (22) by carriers tunnelling between the doped contact layer (23) of the semiconductor portion (23, 24) and the electrically conductive adhesive (22).

## Description

### BACKGROUND OF THE INVENTION

The present invention relates to semiconductor devices-for example semiconductor optoelectronic devices such as photovoltaic cells.

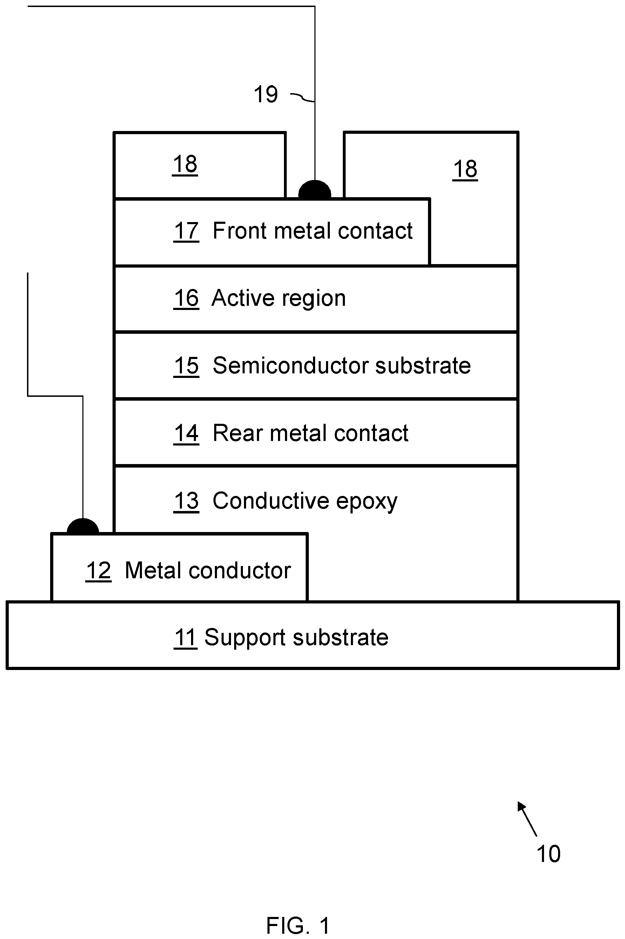

Photovoltaic cells are devices which convert light energy to electrical energy. Fig. 1 shows a schematic cross-section through part of a conventional semiconductor substrate, e.g. group III-V (e.g. GaAs) photovoltaic cell 10. It comprises a layered structure that is bonded to a support substrate 11 (e.g. a printed circuit board) by a conductive epoxy layer 13. The layers include: a rear metal contact layer 14; a group III-V semiconductor substrate 15, on which an active region (layer) 16 containing a semiconductor junction is formed; a patterned front metal contact layer 17; and an antireflective coating layer 18. The rear metal contact layer 14 extends over the entire rear face of the III-V substrate 15, but the front metal contact layer 17 is deposited in a spares pattern (e.g. a grid) across part of the active region 16 of the III-V substrate 15, so that sufficient light still reaches the active region 16 through the top, light-receiving face of the photovoltaic cell 10, for efficiency conversion of light energy to electrical energy in the active region 16.

The front and rear contact layers 14, 17 are provided to collect an electrical current generated by the active region 16 when the cell 10 is exposed to light. The rear metal contact layer 14 is electrically coupled to a metal conductor 12 (e.g. a PCB track or landing pad) of the support substrate 11 via the conductive epoxy 13, while one or more metal wires 19 can be bonded to the front metal contact layer 17 through gaps in the antireflective coating layer 18, e.g. using ball-bonding.

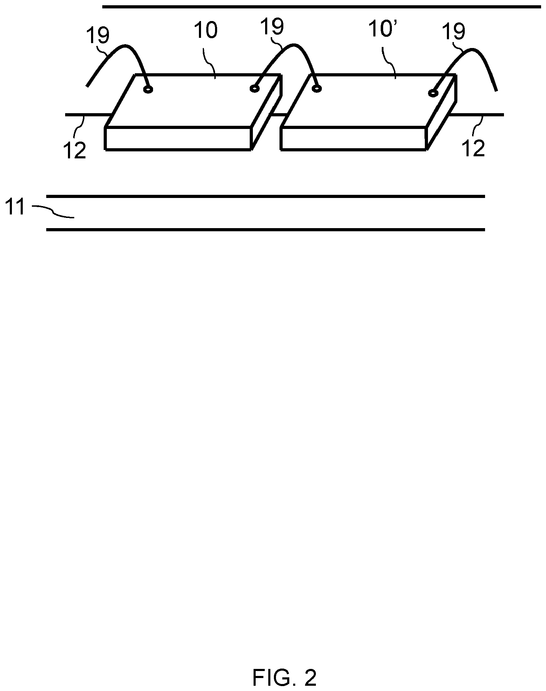

A photovoltaic module may be formed of multiple such cells, electrically connected in series and/or in parallel. Fig. 2 shows an example photovoltaic module formed of a set of such photovoltaic cells 10, 10' wired in parallel, showing the front metal layers 25 interconnected by electrical wires 19, and the rear metal layers 14 interconnected by copper PCB tracks 12 formed on a PCB substrate 11.

The rear metal contact layer 14 is typically deposited onto the semiconductor substrate 15 by electron-beam, thermal, sputtering or electroplating deposition. The rear metal contact layer 14 provides an ohmic contact with the III-V substrate 15, which allows electrical current to flow between the substrate 15 and the metal conductor 12, through the conductive epoxy 13.

Alternatively, metal conductors may be directly coupled (e.g. soldered) to the rear metal contact 14, with a non-conducting adhesive used to mechanically attach the rear metal contact layer 14 to the support substrate 11.

Similar structures can be found in other semiconductor optoelectronic devices, such as in silicon-based photovoltaic cells and in light-emitting diodes.

However, the cost of manufacturing such semiconductor optoelectronic devices is high. Embodiments of the present invention therefore seek to provide semiconductor devices, e.g. semiconductor optoelectronic devices, that may be cheaper to manufacture.

### SUMMARY OF THE INVENTION

When viewed from a first aspect, the invention provides a semiconductor device comprising:
a semiconductor portion comprising a doped contact layer;
a support substrate; and
an electrical conductor for passing an electrical current to or from the semiconductor portion,
wherein:
the semiconductor portion is bonded to the support substrate by an electrically conductive adhesive;
the electrically conductive adhesive is in direct ohmic contact with the doped contact layer of the semiconductor portion;
the electrically conductive adhesive is additionally in direct ohmic contact with the electrical conductor; and
the electrically conductive adhesive is arranged such that all electrical current passing to or from the semiconductor portion travels through the electrically conductive adhesive by carriers tunnelling between the doped contact layer of the semiconductor portion and the electrically conductive adhesive.

When viewed from a second aspect, the invention provides an assembly comprising a plurality of semiconductor devices, each being a device as disclosed herein.

When viewed from a third aspect, the invention provides a method of manufacturing a semiconductor device, the method comprising bonding a semiconductor portion, comprising a doped contact layer, to a support substrate by an electrically conductive adhesive such that:
the electrically conductive adhesive is in direct ohmic contact with the doped contact layer of the semiconductor portion;
the electrically conductive adhesive is additionally in direct ohmic contact with an electrical conductor; and
the electrically conductive adhesive is arranged such that all electrical current passing to or from the semiconductor portion travels through the electrically conductive adhesive by carriers tunnelling between the doped contact layer of the semiconductor portion and the electrically conductive adhesive.

Thus it will be seen that, in accordance with embodiments of the invention, all the electrical current passing to or from the semiconductor portion travels directly into or out of the semiconductor portion from the electrically conductive adhesive by carriers tunnelling between the doped contact layer and the electrically conductive adhesive. Because of this, there is no requirement for the device to have a rear metal contact layer in ohmic contact with the semiconductor portion. Instead, the adhesive is able to pass electrical current directly between the electrical conductor (e.g. a PCB track or landing pad) and the semiconductor portion. Not having a rear metal contact layer simplifies the fabrication of the device, making it cheaper and easier to manufacture.

It has also been determined that this advantage can be obtained while still maintaining the electrical performance of at least certain devices, such as photovoltaic cells, at a comparable level to conventional devices which contain a rear metal contact layer, for at least some embodiments.

Preferred embodiments thus have no monolithic metal (i.e. bulk metal, in contrast to any metal particles that may be suspended within the adhesive) in direct ohmic contact with the doped contact layer of the semiconductor portion. They preferably have no monolithic metal in contact with any part of a rear face of the semiconductor portion.

The semiconductor device may be a planar and/or layered device. It may comprise a stack of layers.

In some embodiments, the semiconductor device may comprise semiconductor substrate (i.e. wafer), such as a group III-V substrate. This may be a thick substrate. The doped contact layer may be provided by the semiconductor substrate. The semiconductor substrate may be uniformly doped, or it may be more heavily doped in the contact layer.

In other embodiments, the semiconductor portion may be an epitaxial lift-off (ELO) portion (i.e. formed by ELO), having been removed from a semiconductor growth substrate. The semiconductor portion may be a thin-film device. It may comprise a dedicated contact layer, which may have been formed on the semiconductor substrate before the semiconductor portion was removed from the wafer.

The doped contact layer may be a planar layer. It may have a uniform thickness. It may define part of all or a face (e.g. rear face) of the semiconductor portion. It may be a rear contact layer. It may comprise one or more doped contact regions. The doped contact layer may be any type of doped semiconductor contact layer. It may be a doped back surface field (BSF) layer. The contact layer may form a single contiguous region. It may span the semiconductor portion, in one or two dimensions. It may span and/or define an entire rear face of the semiconductor portion.

The device may be a semiconductor optoelectronic device. The semiconductor portion may comprise an active region (e.g. an active layer that spans the semiconductor portion), which may be distinct from the doped contact layer. The active region may be a light-emitting or light-absorbing region. It may contain one or more semiconductor junctions. The semiconductor device may be configured to convert electrical energy into light energy, or to convert light energy into electrical energy. It may be any type of semiconductor device. It may be a light-emitting diode, but in some preferred embodiments it is a photovoltaic cell. In some embodiments, the device is a photovoltaic cell for indoor energy harvesting-e.g. arranged to output a current density below 1 mA/cm².

The semiconductor portion preferably comprises all of the semiconductor material of the device. In some embodiments it may comprise a substrate that comprises a majority or all of the semiconductor material of the device. The semiconductor portion of the device may comprise a group III-V material, such as GaAs. However, in other embodiments it may comprise silicon or any other suitable semiconductor material. It may comprise one or more semiconductor layers, some or all of which may be doped layers. It may provide a semiconductor junction, e.g. a p-n junction. It may comprise an active light-emitting or light-absorbing region, and may comprise a light-emitting or light-absorbing junction.

An active (e.g. light-receiving) region may, in some embodiments, occupy a majority of the semiconductor portion-e.g. when the device in an epitaxial lift-off (ELO) photovoltaic cell and so lacks a semiconductor growth-substrate layer.

The doped contact layer may extend from the active region to an interface with the electrically conductive adhesive (e.g. to a rear face of the semiconductor portion).

The doped contact layer is preferably highly doped. It may be p-type doped or n-type doped. It preferably has a carrier concentration of greater than 1 × 10¹⁷ cm⁻³, more preferably 1 × 10¹⁸ cm⁻³ if p-type doped, and greater than 1 × 10¹⁶ cm⁻³, more preferably 1 × 10¹⁸ cm⁻³ if n-type doped. Doping may be achieved through intentional introduction of impurities, also known as dopants, into the material of the semiconductor portion. The type of impurities or dopants depends on the polarity to be achieved (i.e. n-type or p-type) and the specific semiconductor material (for example, GaAs or Si). Examples of impurities or dopants include B, Al, In, P, As and/or Sb when the semiconductor portion is or comprises silicon, and Zn, Be, Mg, Si, Te and/or Ge when the semiconductor portion is or comprises GaAs.

Doping may be uniform throughout the doped contact layer. In the case of a photovoltaic cell comprising both a III-V substrate and an active region, doping may be uniform throughout the III-V substrate. Alternatively, such as in the case of an ELO photovoltaic cell, the dopants may be concentrated near or at the interface between the semiconductor portion and the electrically conductive adhesive.

The electrically conductive adhesive may be the principal or only means by which the semiconductor portion is fastened to the support substrate. It also provides the only electrical connection between the semiconductor portion and the electrical conductor (i.e. there is no parallel electrical path, not through at least some part of the adhesive). The electrically conductive adhesive may be provided as an adhesive layer, which may be adjacent a rear face of the semiconductor portion (i.e. opposite from a light-receiving or light-emitting face). It may cover an entire rear face of the semiconductor portion. The electrically conductive adhesive may comprise a conductive component and an adhesive component. The conductive component may comprise a metal such as Ag, Ni, Cu, or a conductive carbonbased material such as graphite. The adhesive component may comprise a varnish, a synthetic resin, such as an acrylate or epoxy resin or silver-filled polyurethane adhesive, or silicone. In a preferred set of embodiments, the conductive component is silver (Ag), and the adhesive component comprises an epoxy.

The electrical conductor may be a metal conductor, or it may be a non-metal conductor such as a transparent conductive oxide, for example fluorine-doped tin oxide (FTO) or indium-doped tin oxide (ITO), which would typically be coated on a glass substrate. The electrical conductor may be adjacent to (e.g. in contact with and/or bonded to) the support substrate. However, in some embodiments the electrical conductor might not be in contact with the support substrate, but only with the electrically conductive adhesive. The electrical conductor may be an electrical wire.

The support substrate may be a PCB. The electrical conductor may be a printed track or landing pad.

The device may comprise a plurality of electrical conductors, each in direct ohmic contact with the electrically conductive adhesive. The device may be arranged such that all electrical current passing to or from the semiconductor portion travels through a single electrical conductor, or through a plurality of electrical conductors (e.g. in approximately equal proportions).

The semiconductor device may further comprise a front metal contact. It may comprise a front metal contact layer, which may be in ohmic contact with the semiconductor portion, e.g. on an opposite face from the electrically conductive adhesive. The front metal contact layer may be patterned on the semiconductor portion. In some embodiments, manufacturing the device may comprise printing a front metal contact, e.g. using inkjet or screen printing. This can further reduce manufacturing costs compared with using conventional lithographic processes.

The device may further comprise an anti-reflective coating, which may be adjacent an opposite face of the semiconductor portion to the electrically conductive adhesive.

The assembly may comprise one or more further semiconductor devices (e.g. further photovoltaic cells), which may be electrically coupled to the first device (e.g. in series or in parallel). The electrical conductor of the first device may be electrically coupled to a second device of the plurality-e.g. to the equivalent electrical conductor of the second device, or to a front metal contact of the second device. The assembly may be an optoelectronic assembly, such as a photovoltaic module.

Features of any aspect or embodiment described herein may, wherever appropriate, be applied to any other aspect or embodiment described herein. Where reference is made to different embodiments or sets of embodiments, it should be understood that these are not necessarily distinct but may overlap.

### BRIEF DESCRIPTION OF THE DRAWINGS

Certain preferred embodiments of the invention will now be described, by way of example only, with reference to the accompanying drawings, in which:
Fig. 1 is a schematic cross-section across part of a conventional photovoltaic cell;
Fig. 2 is a schematic perspective view of a conventional photovoltaic module comprising a series of interconnected photovoltaic cells;
Fig. 3 is a schematic cross-section across part of a photovoltaic cell embodying the invention that has a III-V substrate;
Fig. 4 is a schematic cross-section across part of an epitaxial lift-off (ELO) photovoltaic cell embodying the invention;
Fig. 5 is a dot plot of open-circuit voltage (V_{OC}) for conventional photovoltaic dies and for photovoltaic dies embodying the invention;
Fig. 6 is a dot plot of short-circuit current (Isc) for conventional photovoltaic dies and for photovoltaic dies embodying the invention;
Fig. 7 is a dot plot of fill factor (FF) for conventional photovoltaic dies and for photovoltaic dies embodying the invention;
Fig. 8 is a dot plot of conversion efficiency (Eff) for conventional photovoltaic dies and for photovoltaic dies embodying the invention; and
Fig. 9 is a dot plot of series resistance (Rs) for conventional photovoltaic dies and for photovoltaic dies embodying the invention.

Embodiments of the invention can be used in the field of semiconductor assemblies, e.g. semiconductor optoelectronic assemblies, such as solar panels, comprising one or more semiconductor optoelectronic devices that can convert electrical energy to light energy (light-emitting devices) and/or light energy to electrical energy (light-absorbing devices). The light may be ultraviolet, visible or infrared light.

Examples of such semiconductor optoelectronic devices and assemblies which have a light-emitting junction include light-emitting diodes (LEDs). Examples of such semiconductor optoelectronic devices and assemblies which have a light-absorbing junction include photovoltaic (e.g. solar) cells, photodiodes, and chargecoupled device (CCD) imaging sensors.

One particular example of an optoelectronic device, described in more detail below, is a photovoltaic cell.

In semiconductor devices embodying the invention, the conventional rear metal contact layer is omitted, and a conductive adhesive is applied directly to the semiconductor portion instead. In some embodiments, the conductive adhesive is in contact with a highly-doped semiconductor contact layer of a semiconductor substrate (e.g. a group III-V wafer), with a separate active region (e.g. containing a p-n junction) formed as a layer on top of the semiconductor substrate. In other embodiments, such as in an ELO photovoltaic cell, the cell is detached from the semiconductor wafer during manufacturing, and instead comprises a doped semiconductor contact layer (originally formed on the semiconductor wafer) as well as an active region with the conductive adhesive being in contact with this semiconductor contact layer. In both cases, the resulting devices may have comparable performance to a conventional device with a rear metal contact layer, but can potentially be manufactured at lower cost.

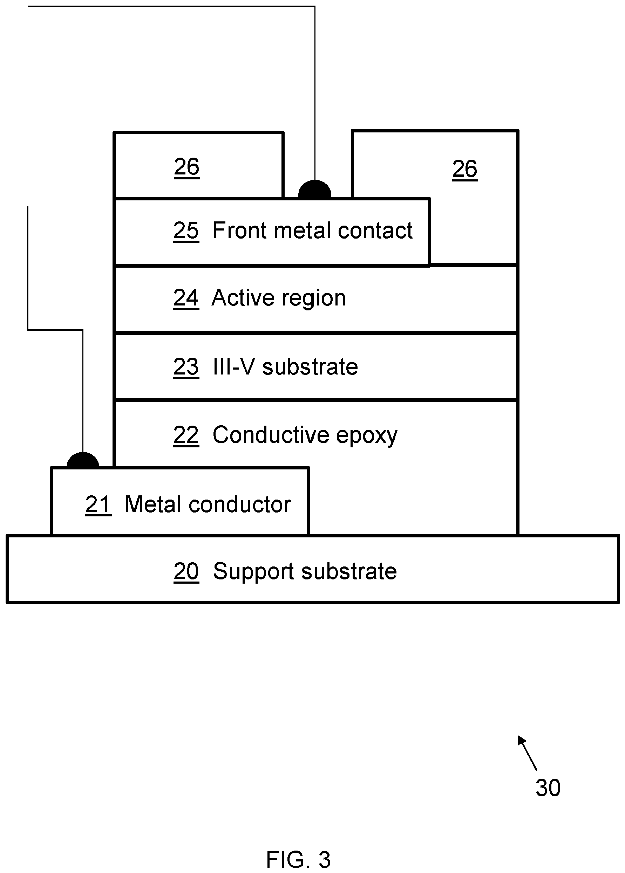

Fig. 3 shows a schematic cross-section through part of a photovoltaic cell 30 according to an embodiment of the invention. It is not drawn to scale. It has a layered structure formed of a support substrate 20 (e.g. a printed circuit board), a silver-loaded electrically-conductive epoxy layer 22, a group III-V (e.g. GaAs) semiconductor substrate (i.e. wafer) 23, upon which a light-receiving active region 24, containing a p-n junction, is formed, a front metal contact layer 25, and an antireflective coating layer (ARC) 26.

In some embodiments, the cell 30 comprises a high band-gap III-V material, with the active region 24 having a direct band-gap in the range of 1.12 eV to 2.0 eV. The front contact layer 25 is provided to collect an electrical current generated by the active region 24 when the cell 30 is exposed to light.

However, in contrast to conventional cells, there is no rear metal contact layer. Instead, the entire rear face of the III-V semiconductor substrate 23 is covered with the electrically conductive epoxy 22, which physically bonds the semiconductor structure to the support substrate 20. The III-V substrate 23 is highly doped between the active region 24 and the epoxy 22, so as to have a carrier concentration of greater than 1 × 10¹⁷ cm⁻³, preferably greater than 1 × 10¹⁸ cm⁻³. The doping is typically uniform throughout the III-V semiconductor substrate 23, although it may be more concentrated towards the interface with the epoxy 22.

Examples of dopants include Zn, Be, Mg, Si, Te and/or Ge when GaAs is the III-V substrate. The III-V substrate 23 thus provides a doped contact layer, as disclosed herein. Because of the high doping of the semiconductor substrate 23, carriers can tunnel between the highly doped semiconductor substrate 23 and the electrically conductive epoxy 22, thereby forming an ohmic contact between them.

The electrically conductive epoxy 22 is also in ohmic contact with a metal conductor 21 (e.g. a PCB track or landing pad) that is bonded to the support substrate 20. The metal conductor 21 and the semiconductor substrate 23 are therefore electrically coupled solely via the conductive epoxy 22. Notably, the level of doping of the semiconductor substrate 23 is such that no direct rear metal contact at all is required to transfer electrical current from the semiconductor substrate 23 to the metal conductor 21. This means that the rear metal contact deposition step in the conventional manufacturing method can be completely eliminated, which achieves significant savings in fabrication costs.

The photovoltaic cell 30, and photovoltaic modules comprising a plurality of such cells 30, may be manufactured generally according to conventional methods known to the person skilled in the art, with the exception that the step of depositing a rear metal contact is not required. In some embodiments, the front metal contact layer 25 may be printed, rather than formed using photolithographic evaporative processes, resulting in further potential cost savings.

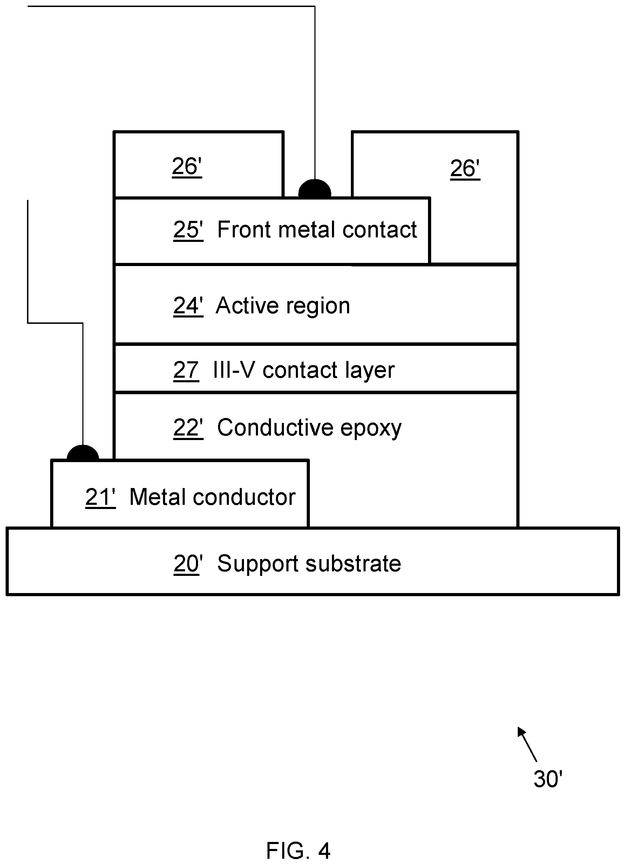

Fig. 4 shows a variant photovoltaic cell 30' which is similar to the photovoltaic cell 30 of Fig. 3 in many respects, but which is manufactured as a substrate-less thin-film device using epitaxial lift-off (ELO). Instead of having the III-V substrate (wafer) 23 shown in Fig. 3, the semiconductor portion of this ELO cell 30' comprises a doped III-V contact layer 27 and a light-receiving active region 24' (containing a p-n junction) that were originally formed on a III-V growth substrate, but were lifted off the III-V substrate during manufacturing. The cell 30' thereafter comprises a III-V semiconductor contact layer 27 and the active region 24', plus front metal contact 25' and ARC 26'. The doped contact layer is provided by the dedicated III-V contact layer 27. This layer 27 may be uniformly doped, or there may be an increase of dopants near the rear interface with the conductive epoxy 22' so as to further reduce the ohmic resistance.

### Experimental validation

In order to test the performance of the photovoltaic cells similar to the cells 30 shown in Fig. 3, a first set of dies (group I), having no back metal layer and embodying the invention, were prepared, along with a second set of dies (group II), having a conventional back metal contact layer. Both sets were analysed under one-sun AM1.5-illumination (i.e. 100 mW/cm²) using a solar simulator. The open circuit voltage (V_{OC}), short-circuit current (I_{SC}), fill factor (FF), conversion efficiency (Eff), and series resistance (R_{S}) were recorded for each die.

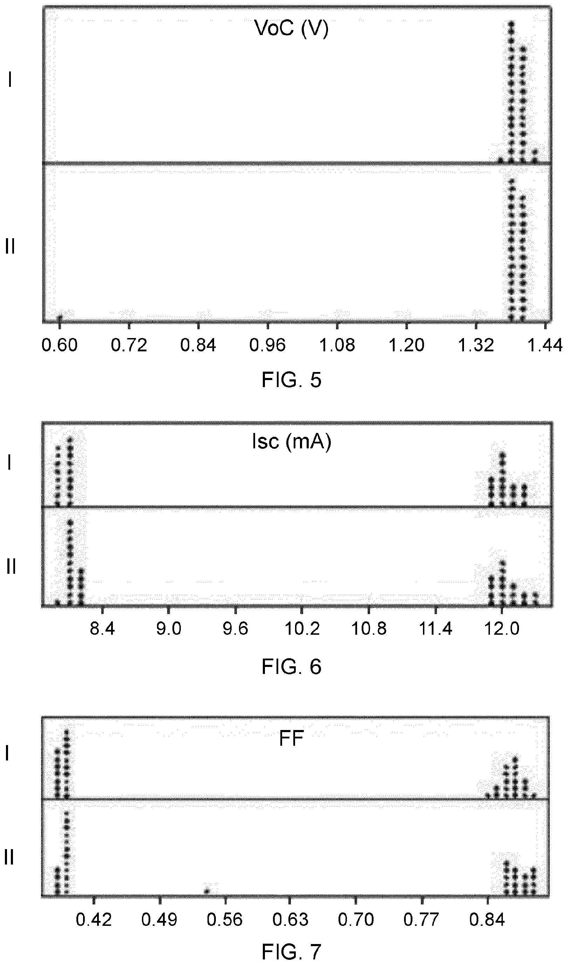

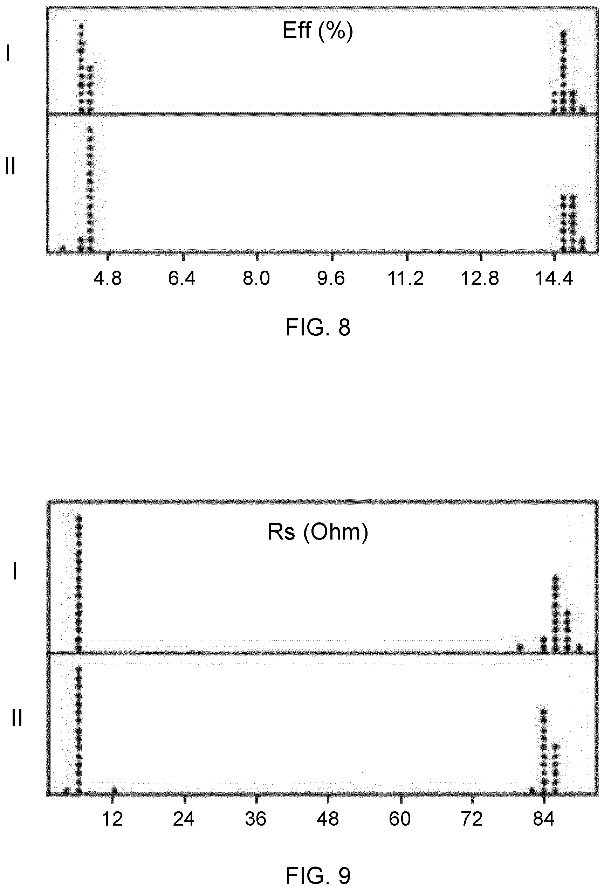

Figs. 5 to 9 group the dies on pairs of vertically-aligned dot plots, in which each dot represents up to two observations. In total, 64 dies are represented for each type. The novel dies are shown in the upper panels (labelled "I"), and the conventional dies are shown in the lower panels (labelled "II").

As can be seen from the figures, the performance of the photovoltaic dies embodying the invention was similar to the conventional photovoltaic dies on all the metrics. This demonstrates that the rear metal contact layer can be eliminated without any loss of performance of the resulting photovoltaic module. In other words, a photovoltaic module of the same performance can be obtained while using a quicker and cheaper manufacturing method.

Though a photovoltaic cell having two particular combinations of layers are shown in Figs. 3 & 4, this is by way of example only, and one or more of these layers may be omitted or replaced by a different layer in others embodiments. Additional layers, not shown or described here, may be present, above or below or within the described layers. The same or similar structures may be used with other types of semiconductor device, such as CCD sensors, LEDs, etc., as well as silicon-based photovoltaic cells.

References to the front or top of a device, and to one layer being above or on another layer, are provided for ease of understanding only, and do not imply that the device must only be manufactured or used in any particular orientation.

It will be appreciated by those skilled in the art that the invention has been illustrated by describing certain specific embodiments thereof, but is not limited to these embodiments; many variations and modifications are possible, within the scope of the accompanying claims.

## Claims

1. A semiconductor device (30) comprising:
a semiconductor portion (23, 24) comprising a doped contact layer (23);
a support substrate (20); and
an electrical conductor (21) for passing an electrical current to or from the semiconductor portion (23, 24),
wherein:
the semiconductor portion (23, 24) is bonded to the support substrate (20) by an electrically conductive adhesive (22);
the electrically conductive adhesive (22) is in direct ohmic contact with the doped contact layer (23) of the semiconductor portion (23, 24);
the electrically conductive adhesive (22) is additionally in direct ohmic contact with the electrical conductor (21); and
the electrically conductive adhesive (22) is arranged such that all electrical current passing to or from the semiconductor portion (23, 24) travels through the electrically conductive adhesive (22) by carriers tunnelling between the doped contact layer (23) of the semiconductor portion (23, 24) and the electrically conductive adhesive (22).

2. The semiconductor device (30) of claim 1, wherein the semiconductor device (30) is an optoelectronic device (30) and wherein the semiconductor portion (23, 24) comprises a light-receiving or light-emitting active region containing a semiconductor junction.

3. The semiconductor device (30) of claim 1 or 2, wherein the doped contact layer (23) of the semiconductor portion (23, 24) is p-type doped and has a carrier concentration of greater than 1 × 10¹⁷ cm⁻³ or is n-type doped and has a carrier concentration of greater than 1 × 10¹⁶ cm⁻³.

4. The semiconductor device (30) of any preceding claim, having no monolithic metal in direct ohmic contact with the doped contact layer (23) of the semiconductor portion (23, 24).

5. The semiconductor device (30) of any preceding claim, wherein the semiconductor device is a photovoltaic cell (30).

6. The semiconductor device (30) of any preceding claim, wherein the semiconductor portion (23, 24) comprises a group III-V material.

7. The semiconductor device (30) of any preceding claim, wherein the electrically conductive adhesive (22) comprises a conductive component of Ag, Ni, Cu or graphite and comprises an adhesive component of a varnish, a synthetic resin, or silicone.

8. The semiconductor device (30) of any preceding claim, wherein the electrically conductive adhesive (22) comprises silver-loaded epoxy.

9. The semiconductor device (30) of any preceding claim, wherein the doped contact layer (23) is a rear contact layer for the semiconductor portion (23, 24), and wherein the electrically conductive adhesive (22) covers an entire rear face of the semiconductor portion (23, 24).

10. The semiconductor device (30) of any preceding claim, wherein the electrical conductor (21) is a metal conductor (21).

11. The semiconductor device (30) of any preceding claim, wherein the electrical conductor (21) is a printed track.

12. The semiconductor device (30) of any preceding claim, wherein the semiconductor portion (23, 24) comprises a semiconductor substrate (23) and the doped contact layer is provided by the semiconductor substrate (23), or wherein semiconductor portion is an epitaxial lift-off portion (27, 24'), and the doped contact layer is provided by a semiconductor contact layer (27) of the epitaxial lift-off portion (27, 24').

13. A method of manufacturing a semiconductor device (30), the method comprising bonding a semiconductor portion (23, 24) having a doped contact layer (23), to a support substrate (20) by an electrically conductive adhesive (22) such that:
the electrically conductive adhesive (22) is in direct ohmic contact with the doped contact layer of the semiconductor portion (23, 24);
the electrically conductive adhesive (22) is additionally in direct ohmic contact with an electrical conductor (21); and
the electrically conductive adhesive (22) is arranged such that all electrical current passing to or from the semiconductor portion (23, 24) travels through the electrically conductive adhesive (22) by carriers tunnelling between the doped contact layer of the semiconductor portion (23, 24) and the electrically conductive adhesive (22).

14. The method of claim 13, wherein the doped contact layer (23) provides a rear contact layer for the semiconductor portion (23, 24), the method further comprising printing a front metal contact on the semiconductor portion (23, 24).

15. The method of claim 13 or 14, wherein the semiconductor device (30) is an optoelectronic device (30) and wherein the semiconductor portion (23, 24) comprises a light-receiving or light-emitting active region containing a semiconductor junction.
